# EUROPEAN PATENT APPLICATION

(11) **EP 4 425 191 A1**
(43) Date of publication of application: **04.09.2024**
(21) Application number: 23382183.4
(22) Date of filing: 28.02.2023
(51) Int. Cl.: G01R 15/04

(54) **A SHIELDED VOLTAGE DIVIDER**

(71) Applicant: Arteche Centro de Tecnologia, A.I.E., 48100 Munguia (Vizcaya) (ES)
(72) Inventor: GARABIETA, IÑAKI, 48100 Munguia, (BIZKAIA) (ES); MONTERO, ALFONSO, 48100 Munguia, (BIZKAIA) (ES)
(74) Representative: Balder IP Law, S.L.

(57) **Abstract**

The invention relates to a shielded voltage divider (8), comprising: a set of resistors (2,3) connected in series between two terminals (4,5) of the voltage divider (8), a non-inductive shielding member (12) disposed around the set of resistors (2,3) and configured for electrically shielding the set of resistors (2,3). The shielding member (12) is formed by at least one resistor, connected between the two terminals (4,5) of the voltage divider (8), and a tubular substrate (11) made of an insulating material. The resistor of the shielding member (12) is a non-inductive resistive conductor (13) supported on one of the faces of the tubular substrate (11). The resistive conductor (13) is bended to configure a serpentine pattern having a plurality of conductor segments (13a-13d) parallel to each other. The shielded voltage divider of the invention, features a simple design and construction, as well as enhanced protection from external parasitic or stray capacitances.

## Description

### TECHNICAL FIELD

The invention relates to a voltage divider provided with a shielding member for isolating the resistors of the voltage divider, against external parasitic or stray capacitances.

An object of the invention is the provision of a shielded voltage divider that features a simple design and construction, as well as enhanced protection against external parasitic or stray capacitances.

### STATE OF THE ART

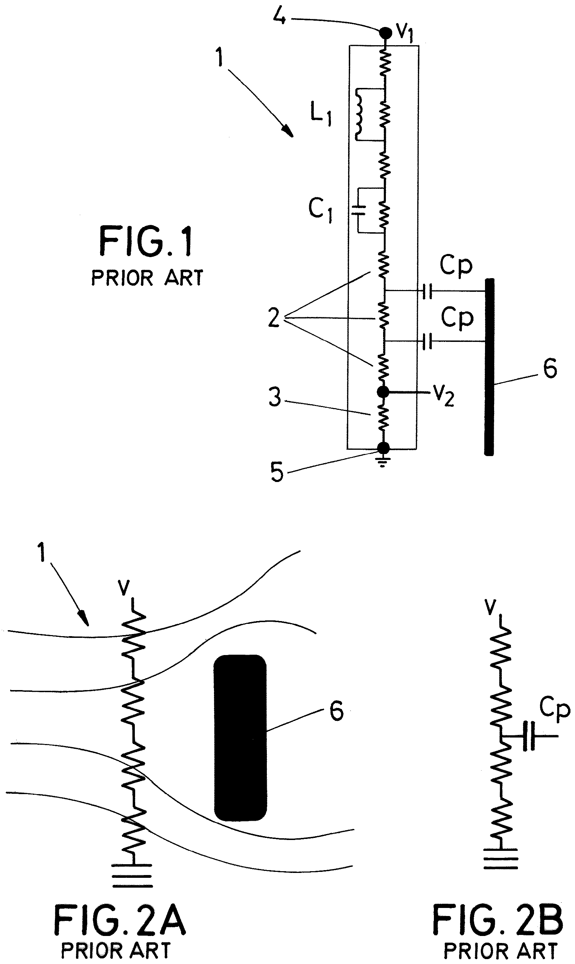

Basically, a voltage divider (1) as the one shown in **Figure 1** is composed of a string of high-voltage resistors (2) and one low-voltage resistor (3) connected in series between two terminals (4,5), such a divided voltage (V2) from a voltage (V1) can be measured at the low voltage resistor (3).

A resistive divider is based on the principle of a voltage divider, in which the impedances are precision pure resistors with little or null capacitance (C1) or inductance (L1) involved in the circuit.

Resistor manufacturers produce these components with very low inductance and internal capacitance, that come very close to the pure resistance concept needed to build a precision resistive divider. Typical resistances are between 50Mohm to 10Gohm depending on the primary voltages to be measured.

However, as represented in **Figure 1****,** it is very difficult to avoid parasitic or stray capacitances (Cp) formed with respect external metallic objects (6) in the vicinity of the voltage divider (1) in its operating environment, that affects the accuracy of voltage measurements.

Any external metallic object (6) with a different voltage (ground, high voltage, etc.), causes the appearance of a parasitic capacitance (Cp) which disturbs the correct function of the voltage divider.

As shown in **Figures 2A** & **2B** an external metallic object (6) disturbs the voltage distribution around a voltage divider (1), that creates parasitic capacitances (Cp) that affect negatively the precision of the voltage divider.

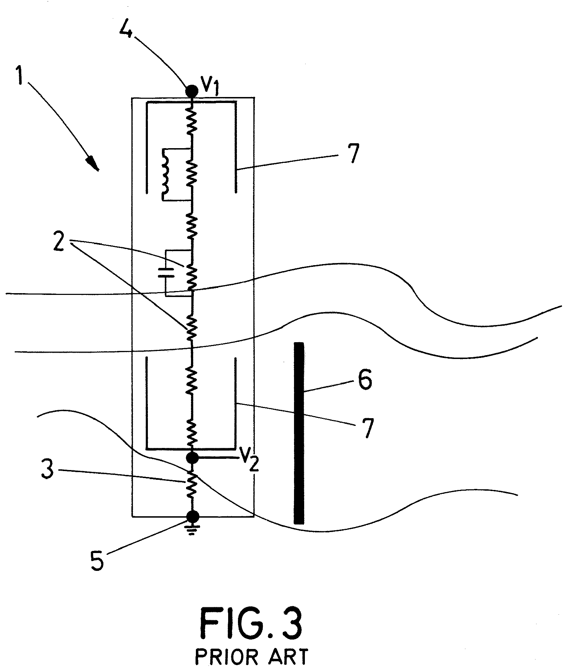

There are some protection solutions as the one shown in **Figure 3****,** that consist of using metallic shields (7) enclosing partially the resistors (2), that mitigate this kind of parasitic capacities, but they have constructive and design difficulties, and depending on the size of the resistive divider, they are not effective.

On another note, non-inductive resistors are known as resistors featuring zero or nearly zero inductance. It is known that non-inductive resistors can be constructed for example by wounding a wire such that the wire is coiled in one direction and then coiled back in opposite direction in a way that the magnetic field created by the part of the wire coiled in one direction, is cancelled by the electromagnetic field created by the wire part coiled in the opposite direction, so practically there will be no electromagnetic flux inside the coil and hence inductance will be zero, so that, the resistor becomes a pure resistance or non-inductive resistance.

Some examples of non-inductive resistors are described in patent applications: JP 2000340414 and US20110128115.

The U. S. patent US-6.580.183 B2 discloses a measuring circuit capable of performing a high-accuracy measurement by eliminating inductive influence from an ambient noise voltage source. An electric circuit including a signal circuit of high impedance, a wiring conductor and a meter is provided with a shielding resistance member having a significantly lower resistance than that of the signal circuit in dependence on an inter-terminal voltage of the high impedance signal circuit and a shield formed of an electrically conductive material disposed in association with the wiring conductor. A voltage distribution function of the shielding resistance member is matched equally to that of an inter-terminal voltage distribution function of the signal circuit. By measuring a line voltage through the medium of the high impedance signal circuit shielded by the shielding resistor, high accuracy measurement can be realized without undergoing adverse influences of parasitic capacitance and induction.

However, the solution disclosed in patent US-6.580.183 B2, is very complex because it requires the shielding member to have a much smaller resistance than the signal circuit (in the order of 100 times smaller), and at the same time to ensure that the electric field through the shielding member is the same as that of the signal circuit. In the claimed invention, neither of these two limitations is necessary.

Therefore, there is the need in this technical field for a voltage divider that features a high degree of protection against parasitic capacitance, close to 100 % protection, and that at the same time, it can be produced by a relatively simple and cost-effective manufacturing process.

### DESCRIPTION OF THE INVENTION

The invention is defined in the attached independent claim, and satisfactorily solves the above-described drawbacks of the prior art, by the provision of a voltage divider conventionally comprising at least one high-voltage resistor and at least one low-voltage resistor at which voltage measurements can be obtained, and wherein all the resistors are connected in series between two terminals of the voltage divider.

A skilled person in the art is familiar with the meaning of the terms high-voltage resistor and low-voltage resistor, which are commonly used in the technical field of voltage dividers. Basically, the low-voltage resistor has a resistive value that divides a fraction of a high-voltage, so that voltage measurements can in practice be obtained by a voltage meter at the low-voltage resistor.

According to the invention, the voltage divider is provided with a non-inductive shielding member, which electrically shields the resistors of the voltage divider to prevent external parasitic or stray capacitances being formed with respect to the resistors. The shielding member is formed by at least one resistor, connected between the two terminals of the voltage divider.

In a preferred embodiment of the invention, all the resistors, that is, the at least one high-voltage resistor and the at least one low-voltage resistor, are enclosed within the non-inductive shielding member. In an alternative embodiment, the at least one high-voltage resistor is enclosed within the non-inductive shielding member, but the low-voltage resistor is outside the non-inductive shielding member, that is, the low-voltage resistor is not enclosed in the non-inductive shielding member.

In a practical use of the invention, one terminal of the resistor of the non-inductive shielding member, and one terminal of the low-voltage resistor, are connected to ground.

Since the high-voltage resistor or the high-voltage resistor and the low-voltage resistors of the voltage divider are surrounded by the resistor or resistors of the non-inductive shielding member, the parasitic capacitances that might be formed with respect to external objects, are derived to ground by the shielding member without affecting the resistors of the voltage divider.

Due to the non-inductive shielding member the electromagnetic field distribution through the voltage divider, is not affected by parasitic capacitances that might appear, so a high precision and reliable voltage divider is obtained.

When the non-inductive shielding member is formed by at least one resistor, this resistor should not be confused with a conventional metallic shield, as the resistive value of a metallic shield can be regarded as cero.

In a preferred embodiment, the non-inductive shielding member comprises a first tubular substrate made of an insulating material, and a first non-inductive resistive conductor applied on one of the faces of the first tubular substrate. The first resistive conductor is bended to configure a serpentine pattern having a plurality of conductor segments parallel to each other, in order to achieve or realize the non-inductive property of the first resistive conductor, that in turn provides the non-inductive feature of the shielding member.

In a preferred embodiment, all the resistor segments of the non-inductive resistive conductor, are equidistantly arranged with respect to each other and have the same length.

The resistive conductor may be formed as a metallic wire, or as an electrically conductive material deposited, for example printed, on a face of the first tubular substrate.

The first tubular substrate may have a circular, squared or other polygonal cross-sectional shape.

The first tubular substrate may be made of: a ceramic material or a glass material, or it may consist of a flexible circuit board.

Additionally, at least one of the resistors of the set of resistors of the voltage divider, either at least one high-voltage resistor or at least one low-voltage resistor, preferably all the resistors of the voltage divider, is also configured as non-inductive resistor. This non-inductive resistor may be composed of a substrate, for example a second tubular substrate, and a second non-inductive resistive conductor, applied on an external surface of the second tubular substrate, and bended to have a serpentine pattern as the one defined above for the resistive conductor of the shielding member. This second non-inductive resistor, has two terminals connected respectively to the ends of the second non-inductive conductor, for the electrical connection of the same.

In an alternative embodiment of the invention, the non-inductive shielding member is also formed by a tubular substrate and a non-inductive resistive conductor applied on the external face of the substrate, and configured as a serpentine pattern as the one defined above for the previous embodiment. In this embodiment, at least one of the resistors of the set of resistors of the voltage divider, preferably all the resistors, are formed on the internal face of the tubular substrate and are configured to have also the serpentine pattern defined above.

### BRIEF DESCRIPTION OF THE DRAWINGS

To complete the description and in order to provide a better understanding of the invention, a set of drawings is provided. These drawings form an integral part of the description and illustrate embodiments of the invention, which should not be interpreted as restricting the scope of the invention, but just as examples of how the invention can be carried out. The drawings comprise the following figures:
Figure 1.- shows a schematic representation of a voltage divider of the prior art, and the effect of external parasitic capacitance on the voltage divider.
Figure 2.- shows in drawing A, a representation of the effect of an external metallic object on the electromagnetic field distribution through a voltage divider, resulting in the parasitic capacitances (drawing B) that affect the precision of the voltage divider.
Figure 3.- shows a schematic representation of a voltage divider of the prior art incorporating metallic shields partially isolating some of the resistors of the divider.

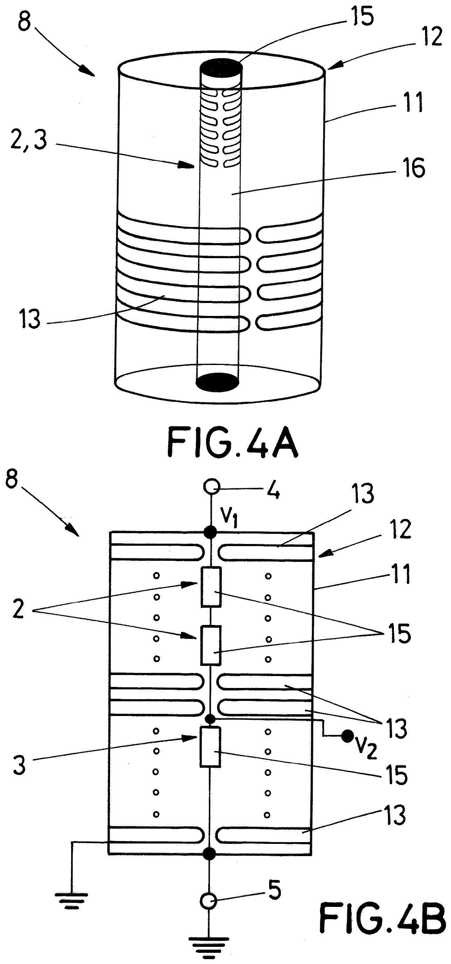

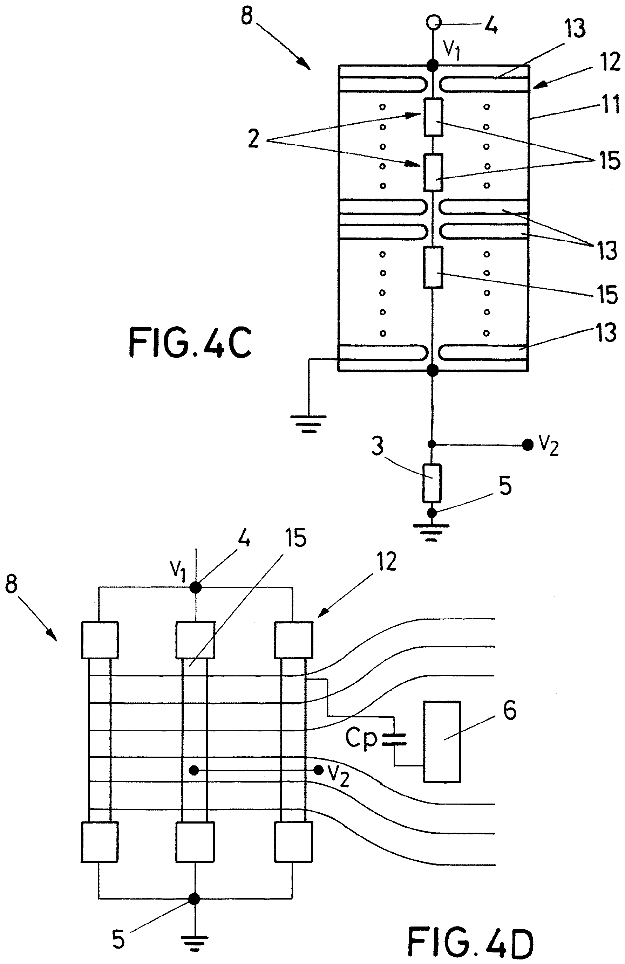

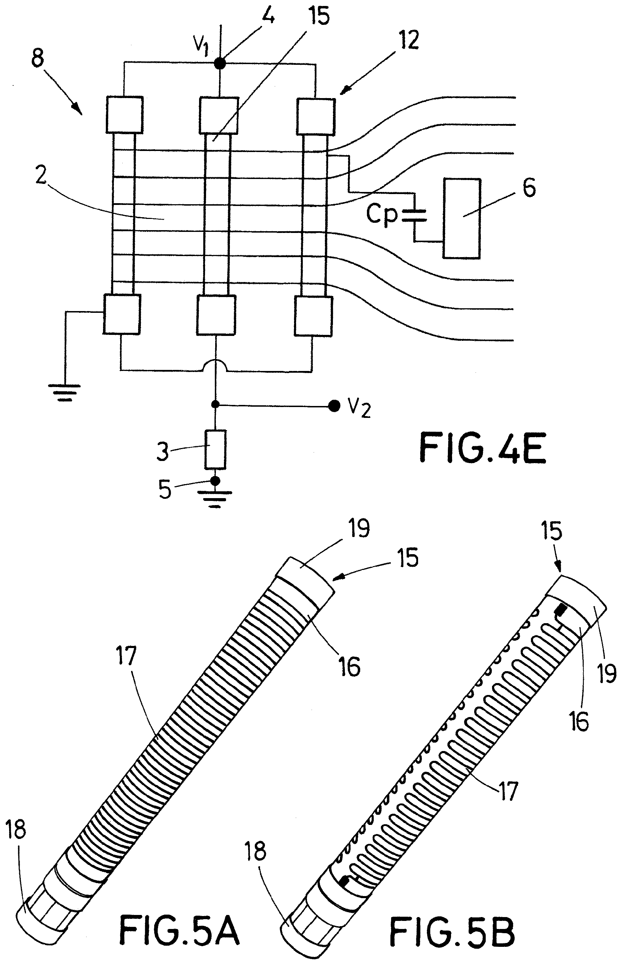

Figure 4.- shows in drawing A a schematic representation in perspective view, of a section of a shielded voltage divider according to the invention, that includes a precision non-inductive resistive voltage divider surrounded by a non-inductive shielding member formed on a tubular substrate. For the sake of simplicity of the illustration, only few turns of the shielding member are shown, but it should be understood, that the non-inductive resistive element may extend in the entire tubular substrate from end to end. Drawing B shows another schematic representation of a voltage divider including several non-inductive resistors, wherein a low-voltage resistor is enclosed within the non-inductive shielding member. Drawing C is the same embodiment of Drawing B but with the low-voltage resistor placed outside de non-inductive shielding member. Drawings D and E represent the shielding effect provided by the shielding member.
Figure 5.- shows two perspective views of one precision non-inductive resistance used in the voltage divider of Figure 4.
Figure 6.- shows the substrate of Figure 4 opened or deployed on a plane in order to illustrate more clearly the serpentine pattern formed by the non-inductive resistance.
Figure 7.- shows in a perspective view a schematic representation of an alternative embodiment of the invention, in which at least one of the resistors of the voltage divider is formed on the internal face of the substrate and conformed to have a serpentine pattern.
Figure 8.- shows two representations of the substrate of Figure 7 opened or deployed on a plane in order to illustrate more clearly the serpentine pattern formed by the non-inductive resistance (Figure 8A) on the external face, and by the resistor of the voltage divider on the internal face (Figure 8B).

### DESCRIPTION OF WAYS OF CARRYING OUT THE INVENTION

**Figure 4A** shows a part of a shielded voltage divider (8) according to a preferred embodiment of the invention, including a shielding member (12) formed by a first tubular cylindrical substrate (11) made of an electrically insulating material, for example a ceramic or a glass material, and a first non-inductive resistor (13) in the form of a wire or thread applied on one of the faces of the tubular substrate (11), either on the internal face or on the external face.

This first non-inductive resistor (13) can be formed as a metallic wire attached to the first tubular substrate (11), or as an electrically conductive material deposited, for example printed, on a face of the first tubular substrate (11).

**Figure 4B** shows a complete shielded voltage divider (8), comprising a set of high-voltage resistors (2) and a low-voltage resistor (3) connected in series between two terminals (4,5), wherein all the resistors (2,3) are enclosed inside the first non-inductive shielding member (12).

In the embodiment of **Figures 4C****,** **4E** only the high-voltage resistors (2) are enclosed within the shielding member (12), and the low-voltage resistor (3) is placed outside the shielding member (12), so that voltage measurements can be obtained at the low-voltage resistor (3).

In a practical use of the shielded voltage divider (8), one terminal of the resistor (13) of the non-inductive shielding member (12), and one terminal of the low-voltage resistor (3), are connected to ground as shown in **Figures 4B** - **4E****.**

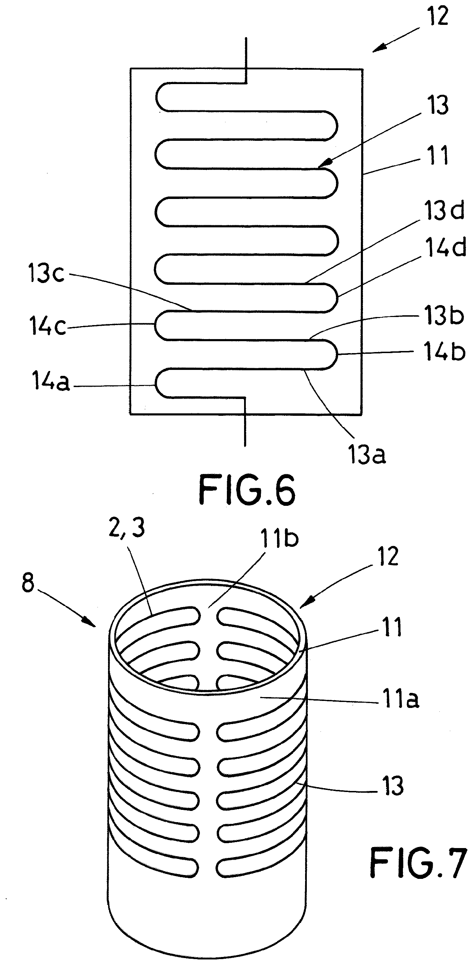

In order to achieve the non-inductive property, the first non-inductive resistor (13) is bended as to configure a serpentine pattern having a plurality of resistor segments (13a - 13d) parallel to each other, as better shown in **Figure 6** and alternately connected at their ends by U-shaped connection segments (14a - 14d).

In this way, the electromagnetic field created at one of the resistor segments (13a - 13d) is cancelled by the electromagnetic field created by adjacent resistor segments (13a - 13d) of the same magnitude and opposite direction, so practically there is no electromagnetic flux and inductance is zero, hence the resistor becomes a pure resistance or non-inductive resistance.

Preferably, all the resistor segments (13a - 13d) are equidistantly arranged and have the same length. Additionally, the resistor segments (13a - 13d) are curved following the curvature of the cylindrical substrate (11) as shown in **Figure 4A****.**

In alternative embodiments of the invention, the first tubular substrate (11) may have squared, or polygonal cross-sectional shape.

In the embodiment of **Figure 4A** and **4B****,** at least one of the resistors (2,3) of the set of resistors of the voltage divider, is a precision non-inductive resistor (15) as the one shown in **Figures 5A, 5B****,** coaxially arranged with respect the first cylindrical tubular substrate (11).

As represented in **Figure 4D****,** due to the non-inductive shielding member (12), the voltage inside the non-inductive shielding member (12), is not affected by an external object (6), an any parasitic capacitance (Cp) that might formed, is formed with the non-inductive shielding member (12) instead of the resistors of the voltage divider.

The precision non-inductive resistor (15) is formed by a second tubular substrate (16) and a second non-inductive resistive conductor (17) conformed with a similar serpentine pattern defined above for the non-inductive resistor (13) and shown in **Figure 6****.**

The second non-inductive resistive conductor (17) is connected at its ends to respective connection terminals (18,19).

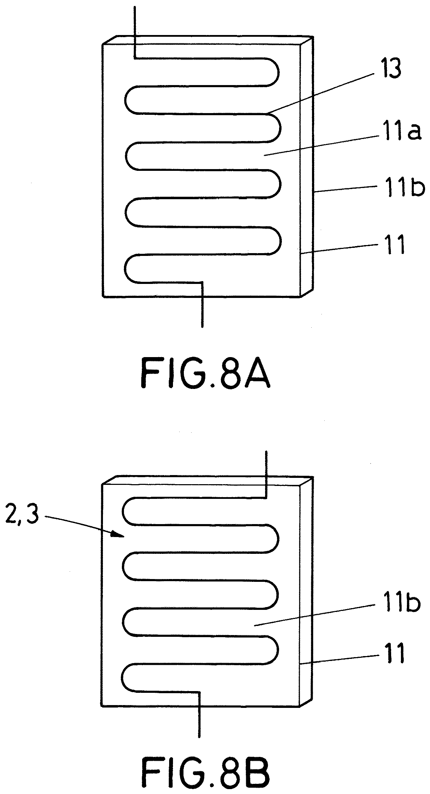

In the alternative embodiment of **Figure 7****,** the first non-inductive resistive conductor (13) of the non-inductive shielding member (12) is formed on the external face (11b) of the first tubular substrate (11), having the serpentine pattern shown in **Figure 8A****,** and at least one of the resistors (2,3) of the set of resistors of the voltage divider, is formed on the internal face (11b) of the first tubular substrate (11) and it is configured to have also a serpentine pattern as the one shown in **Figure 8B****,** to feature the non-inductive property.

Preferably, all the resistors of the set of resistors of the voltage divider, are formed on the internal face of the first tubular substrate (11).

## Claims

1. A shielded voltage divider (8), comprising:
at least one high-voltage resistor (2) and at least one low-voltage resistor (3) connected in series between two terminals (4,5) of the voltage divider (8),
a non-inductive shielding member (12) disposed around the at least one high-voltage resistor (2) and configured for electrically shielding the at least one high-voltage resistor (2) to prevent parasitic capacitances being formed with respect to the at least one high-voltage resistor (2),
wherein the shielding member (12) comprises at least one resistor, and a first tubular substrate (11) made of an insulating material,
wherein the resistor of the shielding member (12) is a first non-inductive resistive conductor (13) supported on one of the faces of the first tubular substrate (11), and
wherein the resistive conductor (13) is bended to configure a serpentine pattern having a plurality of conductor segments (13a-13d) parallel to each other to realize the non-inductive property of the resistive conductor (13).

2. A shielded voltage divider according to claim 1, wherein the at least one low-voltage resistor (3) is also enclosed inside the non-inductive shielding member (12).

3. A shielded voltage divider according to claim 1, wherein the at least one low-voltage resistor (3) is placed outside the non-inductive shielding member (12).

4. A shielded voltage divider according to any of the preceding claims, wherein at least one of the resistors (2,3) of the set of resistors of the voltage divider (8), is a non-inductive resistor (15).

5. A shielded voltage divider according to claim 4, wherein the non-inductive resistor (15) of the voltage divider, comprises a second tubular substrate (16), and a second non-inductive resistive conductor (17) formed on an external surface of the second tubular substrate (16), and bended to have a serpentine pattern to feature the non-inductive property, and two connection terminals (18,19) connected respectively to the ends of the second non-inductive resistive conductor (17).

6. A shielded voltage divider according to claim 5, wherein the first non-inductive resistive conductor (13) is supported on an external face of the first tubular substrate (11), and wherein the first tubular substrate (11) surrounds the second tubular substrate (16).

7. A shielded voltage divider according to any of the preceding claims, wherein all the resistors (2,3) of the set of resistors of the voltage divider (8), are non-inductive resistors.

8. A shielded voltage divider according to claim 1, wherein the first non-inductive resistive conductor (13) of the non-inductive shielding member (12) is formed on an external face of the first tubular substrate (11), and wherein at least one of the resistors of the set of resistors (2,3) of the voltage divider, is formed on an internal face of the first tubular substrate (11) and it is configured to have also a serpentine pattern to feature the non-inductive property.

9. A shielded voltage divider according to claim 8, wherein all the resistors (2,3) of the set of resistors of the voltage divider, or the at least one high-voltage resistor (3), are or is formed on the internal face of the first tubular substrate (11).

10. A shielded voltage divider according to any of the preceding claims, wherein all the resistor segments (13a -13d) of the serpentine pattern are equidistantly arranged with respect to each other, and all the resistor segments (13a - 13d) have substantially the same length.

11. A shielded voltage divider according to any of the preceding claims, wherein the first resistive conductor (13) is a metallic wire, or an electrically conductive material deposited on a face of the first tubular substrate (11).

12. A shielded voltage divider according to claim 5, wherein the second resistive conductor (17) is a metallic wire, or an electrically conductive material deposited on a face of the second tubular substrate (16).

13. A shielded voltage divider according to any of the preceding claims, wherein the cross-sectional view of the tubular substrate (11) has a circular, squared, or polygonal shape.

14. A shielded voltage divider according to any of preceding claims, wherein the tubular substrate (11) is made of: a ceramic, a glass material or flexible circuit board.

15. A shielded voltage divider according to any of the preceding claims, wherein one terminal of the resistor (13) of the non-inductive shielding member (12), and one terminal of the low-voltage resistor (3) are connected to ground.
